# EUROPEAN PATENT SPECIFICATION

(11) **EP 4 414 483 B1**
(45) Date of publication and mention of the grant of the patent: **22.07.2026**
(21) Application number: 22878226.4
(22) Date of filing: 25.08.2022
(51) Int. Cl.: C30B 29/62, C23C 16/42, C23C 16/56, C30B 25/02, C30B 33/00, C23C 16/32, C30B 25/18, C30B 29/36, C30B 33/06, C23C 16/02, H10P 14/24, H10P 14/20

(54) **METHOD FOR FORMING HETEROEPITAXIAL FILM**
VERFAHREN ZUR HERSTELLUNG EINER HETEROEPITAKTISCHEN SCHICHT
PROCÉDÉ POUR LA FORMATION D'UN FILM HÉTÉROÉPITAXIAL

(30) Priority: 06.10.2021 JP 2021164648
(43) Date of publication of application: 14.08.2024
(73) Proprietor: Shin-Etsu Handotai Co., Ltd., Tokyo 100-0004 (JP)
(72) Inventor: OHTSUKI, Tsuyoshi, Nishishirakawa-gun, Fukushima 961-8061 (JP); HAGIMOTO, Kazunori, Annaka-shi, Gunma 379-0196 (JP); ISHIZAKI, Junya, Annaka-shi, Gunma 379-0196 (JP); ABE, Tatsuo, Nishishirakawa-gun, Fukushima 961-8061 (JP); SUZUKI, Atsushi, Nishishirakawa-gun, Fukushima 961-8061 (JP); MATSUBARA, Toshiki, Nishishirakawa-gun, Fukushima 961-8061 (JP)
(74) Representative: Mooser, Sebastian Thomas
(86) International application number: PCT/JP2022/032016
(87) International publication number: WO 2023/058355

(56) References cited:
- JP-A- 2005 347 666
- JP-A- 2006 036 609
- JP-A- 2006 253 617
- JP-A- 2011 071 219
- JP-A- 2014 237 581
- JP-A- 2018 070 435
- US-A1- 2002 102 862
- KOMIYAMA J ET AL: "Schottky diode characteristics of 3C-SiC grown on a Si substrate by vapor phase epitaxy", JOURNAL OF CRYSTAL GROWTH, ELSEVIER, AMSTERDAM, NL, vol. 275, no. 1-2, 15 February 2005 (2005-02-15), pages e1001 - e1006, XP027849702, ISSN: 0022-0248, [retrieved on 20050215]

## Description

### TECHNICAL FIELD

The present invention relates to a method for producing a heteroepitaxial film.

### BACKGROUND ART

Most devices formed on silicon substrates, such as advanced CMOS (Complementary Metal Oxide Silicon) or IGBT (Insulated Gate Bipolar Transistor), are not used at an initial silicon substrate thickness intact but are used in a thin filmed form by methods such as grinding in most cases. This is because thick silicon substrates make the substrates resistive and thus problematic. On the other hand, the thin silicon substrates from the beginning may warp during a process, making the substrates impossible to pass through a device process, thus thickness is required. Meanwhile, in addition to conventional miniaturization, recent devices have employed integration by methods such as Chip on Wafer, in which cut-out devices are attached to wafers prewired with metal wiring. In this case, the devices to be cut out are also thinned, and most silicon substrates are removed.

In addition, materials other than silicon have been actively used in devices, contributing to higher performance. Among them, SiC has a wider bandgap of 2.2 to 3.3 eV, compared with a bandgap of Si of 1.1 eV, which gives a high dielectric breakdown strength and high thermal conductivity, making it a promising material as a semiconductor material for various semiconductor devices such as power devices and highfrequency devices. Moreover, non-patent document 1 describes a method to form a 3C-SiC single crystal film on a single crystal silicon substrate.

Considering these factors, for example, Patent Documents 1, 2, and 3 propose techniques in which ion implantation, such as hydrogen, is applied to SiC or silicon, and then the substrate is delaminated from this implantation layer. With these methods, a thin-film side can be reused as a device, and a thick-film side can be reused as a substrate once more (although surface polishing is required) after delaminating. Thus, these methods have great merits. However, these methods perform delaminating by creating a frangible layer with ion implantation such as hydrogen, thus an ion implantation apparatus is needed (this is particularly expensive for a large diameter substrate), and timing to form the frangible layer is extremely difficult (when the frangible layer is formed at an early stage of the process, it is highly likely that a crack is generated because of a thermal step during the process. On the other hand, when the layer is formed in the latter stage of the process, the device that has been formed is destroyed by ion implantation). Therefore, a practical application still has a hurdle.

### CITATION LIST

### PATENT LITERATURE

Patent Document 1: JP 2010-251724 A
Patent Document 2: JP 2011-223011 A
Patent Document 3: JP 2010-502023 A
Non-patent document 1: Jun Komiyama et al., Schottky diode characteristics of 3C-SiC grown on a Si substrate by vapor phase epitaxy, J. Cryst. Growth 275 (2005) e1001-e1006

### SUMMARY OF INVENTION

### TECHNICAL PROBLEM

The present invention has been made in view of solving the above-described problem and efficiently obtaining a heteroepitaxial film in a thin film shape with less damage to a device and less material loss.

### SOLUTION TO PROBLEM

To achieve the object described above, the present invention provides a method for producing a heteroepitaxial film, including a step of heteroepitaxially growing a 3C-SiC single crystal film on a single crystal silicon substrate and then delaminating the 3C-SiC single crystal film from the single crystal silicon substrate, the method comprising: with using a reduced-pressure CVD apparatus,
a first step of removing a native oxide film on a surface of the single crystal silicon substrate by hydrogen baking;
a second step of performing nucleation of SiC on the single crystal silicon substrate on condition of pressure of 1333 Pa or lower and a temperature of 300°C or higher and 950°C or lower and a third step of forming the 3C-SiC single crystal film by growing a SiC single crystal and forming a vacancy directly under the 3C-SiC single crystal film on condition of pressure of 1333 Pa or lower and a temperature of 800°C or higher and lower than 1200°C, while supplying a source gas containing carbon and silicon into the reduced-pressure CVD apparatus; and
a fourth step of producing the heteroepitaxial film by separating and delaminating the 3C-SiC single crystal film from the single crystal silicon substrate along the vacancy.

In this way, by removing the native oxide film on the surface of the single crystal silicon substrate in the first step, the nucleation of SiC becomes possible in the second step.

In addition, by combining pressure and temperature conditions that facilitate the nucleation of SiC in the second step and pressure and temperature conditions that facilitate the growth of the SiC single crystal in the third step, it is possible to efficiently produce the heteroepitaxial wafer with 3C-SiC single crystal film having the excellent quality.

Moreover, making the pressure 1333 Pa (10 Torr) or lower can prevent reactions of secondary or higher orders, such as a reaction of reactive active species with a raw material gas in the gas phase, thus ensuring the heteroepitaxial growth. Thereby, polycrystallization of 3C-SiC can be prevented. Furthermore, the vacancy can be formed in a silicon layer (single crystal silicon substrate) (hereinafter, also referred to as an interface between 3C-SiC and silicon) directly under the 3C-SiC single crystal film while growing the 3C-SiC single crystal film. The presence of the vacancy not only relaxes a lattice mismatch between 3C-SiC and silicon but also the stress-relaxes of an entire epitaxial layer, thus enabling more reliable formation of the 3C-SiC single crystal film without crystal defects even for a thick 3C-SiC single crystal film.

As described above, by combining pressure and temperature conditions, which facilitate the nucleation of SiC, and pressure and temperature conditions, which facilitate a growth of the SiC single crystal and form a vacancy at an interface between SiC and silicon, a heteroepitaxial wafer having the 3C-SiC single crystal film can be efficiently obtained. Moreover, in the fourth step, separating and delaminating along the vacancy at the interface between 3C-SiC and silicon, a heteroepitaxial film, including an objective 3C-SiC single crystal film, can be efficiently obtained.

Furthermore, because of the delamination at the interface between 3C-SiC and silicon, the separation can be performed with a small loss of a single crystal silicon substrate. In other words, a thicker single crystal silicon substrate can be obtained after separation, which is effective in terms of reuse.

For example, even in the case of delaminating after forming the device on the 3C-SiC single crystal film, damage to the device is small.

In this case, the source gas can be monomethylsilane or trimethylsilane.

Such a raw material gas can supply both Si and C by a single gas, thus, a step of nucleation, which is called carbonization before the 3C-SiC single crystal film growth, as in the conventional method, is also unnecessary, in which a carbon atom is attached to the surface of the single crystal silicon substrate by the gas containing carbon source precursor. Then, forming the 3C-SiC single crystal film is enabled on a very simple condition.

Moreover, compared with a conventional method, in which the carbon atom is first attached on the surface of the single crystal silicon substrate by a gas containing carbon source precursor for nucleation and then the 3C-SiC single crystal film is formed using the gas containing carbon source precursor and a gas containing silicon source precursor; the reactive active species in the gas phase are more controllable, and the heteroepitaxial growth is more reliable, thereby forming the thick 3C-SiC single crystal film much easier without stopping the growth of a 3C-SiC single crystal.

Meanwhile, the first step can be performed on condition of a temperature of 1000°C or higher and 1200°C or lower.

By using such a temperature condition, the native oxide film on the surface of the single crystal silicon substrate can be removed more efficiently, and the 3C-SiC single crystal film can be formed more reliably. Moreover, the generation of slip dislocations can be prevented.

In addition, the third step can be performed on condition of pressure of 133 Pa or lower.

In this way, by making the pressure 133 Pa (1 Torr) or lower in the third step, the vacancy can be formed more reliably at the interface between 3C-SiC and silicon while growing 3C-SiC single crystal film and the 3C-SiC single crystal film (heteroepitaxial film) can be delaminated more reliably in the fourth step.

Meanwhile, the third step can be performed with one or more of pressure and temperature higher than the condition of the second step.

The third step can be performed on the condition identical to the condition of the second step, but when the condition is described above, a growth rate of the 3C-SiC single crystal film can be much faster in the third step. Thus, the formation can be performed efficiently even when forming the thick 3C-SiC single crystal film.

In this case, the third step can be performed on condition of a temperature of 1000°C or higher and lower than 1200°C.

On this growth condition, the heteroepitaxial growth can be controlled by transport of the supply gas and is not restricted by such as limitation of the plane orientation of the single crystal silicon substrate to make the lattice mismatch between silicon and SiC smaller, which is generated in another conventional method. There is no need to form a frangible layer such as hydrogen by ion implantation, and the 3C-SiC single crystal film can be grown more reliably. Furthermore, the 3C-SiC single crystal film can be more easily formed on a single silicon substrate, for example, with a large diameter of such as 300 mm.

Meanwhile, one or more of the pressure and temperature can be raised higher during the third step.

With this method, it is possible to make the conditions of the pressure to, for example, 133 Pa (1 Torr) or lower in an initial stage of the third step and then raise the pressure to accelerate the film-formation rate. Similarly, the temperature can be raised to a high temperature to accelerate the film-formation rate from the middle of the stage.

In this case, the second step and the third step are performed on condition of gradually raising a temperature from a range from 300°C or higher to 950°C or lower to the range from 1000°C or higher to lower than 1200°C,
thereby performing the nucleation of SiC and the formation of the 3C-SiC single crystal film following the nucleation of SiC in succession.

In this way, the heteroepitaxial growth can be controlled by transport of the supply gas and cannot be restricted by the plane orientation of the single crystal silicon substrate, and containing hydrogen is unnecessary. Moreover, the 3C-SiC single crystal film can be more easily formed on a single crystal silicon substrate having a large diameter.

Besides, the temperature rise can be at a rate of temperature rise of 0.5°C/sec or faster and 2°C/sec or slower.

With such a rate of temperature rise, controlling the temperature can be performed more reliably. In addition, uniform nucleation of SiC can be performed, and the generation of defects during heteroepitaxial growth can be effectively prevented.

Moreover, after the third step and before the fourth step, a GaN layer can be formed on a surface of the formed 3C-SiC single crystal film by further growing GaN thereon, or after the third step and before the fourth step, a Si layer can be formed on a surface of the formed 3C-SiC single crystal film by further growing Si thereon.

The 3C-SiC single crystal film grown as described above has a flat surface. Thus, the GaN layer or the Si layer can be further heteroepitaxial grown on the surface of the 3C-SiC single crystal film.

Meanwhile, after the third step, a protective film can be formed on the formed 3C-SiC single crystal film, and then the fourth step can be performed. Otherwise, after the third step, a device can be formed and a protective film can be formed on the formed 3C-SiC single crystal film, and then the fourth step can be performed. Alternatively, after the third step, the device can be formed on the formed 3C-SiC single crystal film, and the protective film can be formed after the device is cut out along a scribe line of the device, and then the fourth step can be performed.

In this way, the 3C-SiC single crystal film can be delaminated intact, or can be delaminated after the formation of the device.

### ADVANTAGEOUS EFFECTS OF INVENTION

According to the inventive method for producing the heteroepitaxial film, heteroepitaxial growth of the 3C-SiC single crystal film is performed efficiently on the single crystal silicon substrate so as to generate the vacancy in the silicon substrate (the interface between 3C-SiC and silicon) while maintaining excellent 3C-SiC single crystalline, and the heteroepitaxial film in a thin film shape can be efficiently obtained by delaminating the 3C-SiC single crystal film from the silicon substrate using this vacancy. It is also extremely effective in terms of damage to the device and material loss. Furthermore, by using SiC as an underlayer, such heteroepitaxial film can improve device isolation due to an insulating property with characteristics of a wide bandgap and cooling efficiency due to high thermal conductivity.

### BRIEF DESCRIPTION OF DRAWINGS

FIG. 1 is a flowchart illustrating an example of a method for producing a heteroepitaxial film according to the present invention.
FIG. 2 is a graph illustrating an example of a growth sequence from the first step to the third step of the first embodiment.
FIG. 3 is a flow diagram illustrating an example of a state to produce a heteroepitaxial film by delaminating a 3C-SiC single crystal film from a single crystal silicon substrate.
FIG. 4 is a flow diagram illustrating another example of a state to produce a heteroepitaxial film by delaminating a 3C-SiC single crystal film from a single crystal silicon substrate.
FIG. 5 is a graph illustrating an example of a growth sequence from a first step to a third step of the second embodiment.
FIG. 6 is a graph illustrating an example of a growth sequence from a first step to a third step of the third embodiment.
FIG. 7 is a graph illustrating a result of In plane XRD analysis of SiC on Si (111) grown in Example 1 (the first embodiment).
FIG. 8 is a measurement diagram illustrating a cross-sectional TEM image of SiC on Si of Example 1 (the first embodiment).
FIG. 9 is a measurement diagram illustrating a cross-sectional TEM image of SiC on Si of Example 2 (the second embodiment).

### DESCRIPTION OF EMBODIMENTS

Hereinafter, embodiments of the present invention will be described with reference to the drawings. However, the present invention is not limited thereto.

As described above, a method of efficiently obtaining a heteroepitaxial film (a 3C-SiC single crystal film) has been required. The present inventors, therefore, have earnestly studied and found out that; with using a reduced-pressure CVD apparatus, in addition to hydrogen baking for removing a native oxide film on a surface of a single crystal silicon substrate (First Step), while supplying source gas (containing carbon and silicon), by combining a predetermined condition with respect to pressure and temperature (pressure of 1333 Pa or lower and a temperature of 300°C or higher and 950°C or lower) that facilitates nucleation of SiC (Second Step) and a predetermined condition (pressure of 1333 Pa or lower and a temperature of 800°C or higher and lower than 1200°C) to facilitate a growth of a SiC single crystal and form a vacancy at an interface between 3C-SiC and silicon (Third Step), then the 3C-SiC single crystal film with excellent quality can be efficiently formed; and even more, when the 3C-SiC single crystal film is separated and delaminated from the single crystal silicon substrate along the vacancy (Fourth Step); the heteroepitaxial film can be efficiently obtained. This finding has led to the completion of the present invention.

Hereinafter, each step is described, referring to various specific examples.

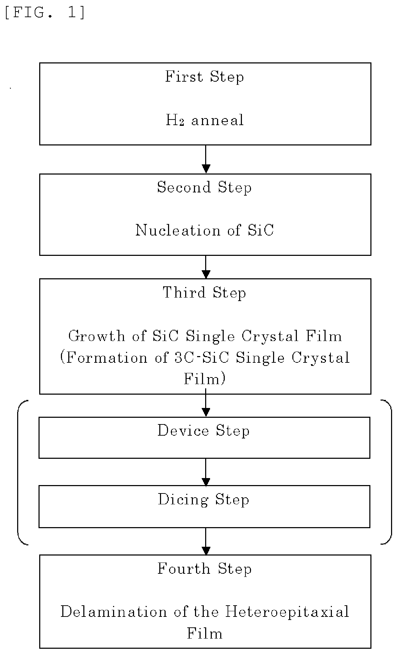

FIG. 1 is a flowchart illustrating an example of the inventive method for producing the heteroepitaxial film. At this point, hydrogen baking (hereinafter, also referred to as H₂ anneal) as a first step, the nucleation step of SiC as a second step, a growth step of a SiC single crystal as a third step (formation step of 3C-SiC single crystal film), a device step and a dicing step if necessary, and delamination of the heteroepitaxial film (3C-SiC single crystal film) as a fourth step are performed in sequence.

### (First Embodiment)

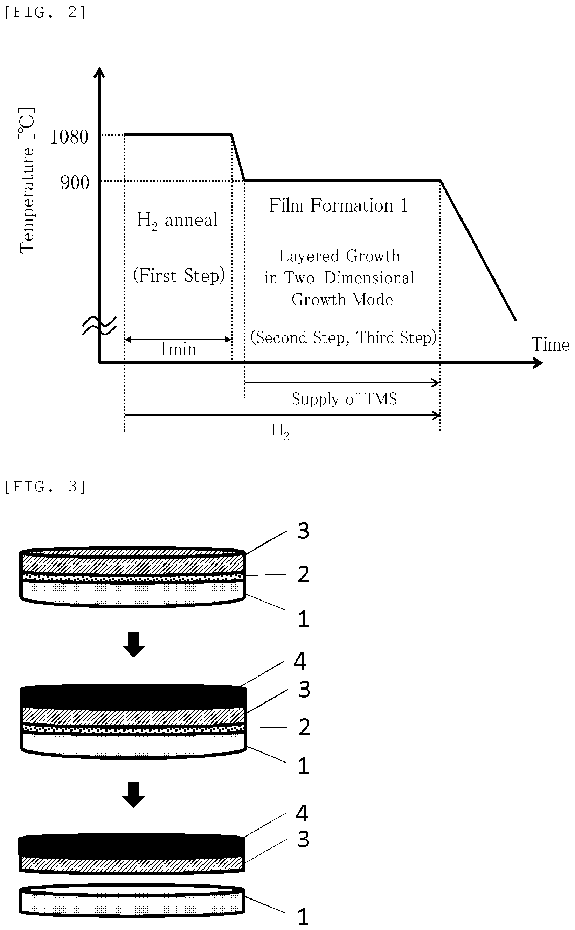

FIG. 2. shows an example of a growth sequence in a first step to a third step of the first embodiment. Hereinafter, each step is described.

### <First Step>

To begin with, a single crystal silicon substrate is placed in a reduced-pressure CVD apparatus (hereinafter, also referred to as an RP-CVD apparatus), a hydrogen gas is introduced, and then a native oxide film on the surface is removed by H₂ anneal. When an oxide film remains, the nucleation of SiC on the single crystal silicon substrate becomes impossible. H₂ anneal, in this case, is preferably on condition of, for example, a temperature of 1000°C or higher and 1200°C or lower. Making the temperature 1000°C or higher can prevent long processing time to prevent residual native oxide film, thus being efficient. Meanwhile, making the temperature 1200°C or lower can effectively prevent a generation of a slip dislocation due to high temperature. However, the pressure or time of H₂ anneal at the time has no particular restriction as long as the native oxide film can be removed.

In the example shown in FIG. 2, H₂ anneal is performed at 1080°C for one minute. Meanwhile, the introduction of the hydrogen gas can be continued in the second and third steps after this first step (carrier gas).

### <Second Step>

Then, the single crystal silicon substrate is set to a predetermined pressure and temperature, and a source gas containing carbon and silicon is introduced as a raw material gas for SiC into the RP-CVD apparatus, and then the nucleation of SiC is performed. Monomethylsilane or trimethylsilane (TMS) can be introduced as the source gas, for example. It is simpler and easier to control than using a plurality of types of gases, and more reliable formation of the 3C-SiC single crystal film is possible. Further, since C has smaller atoms and vaporizes more easily than Si, trimethylsilane is easier for a condition setting regarding raw material efficiency.

Such introduction of the source gas is performed in this second step and the following third step.

Moreover, this nucleation of SiC can be performed on the surface of the single crystal silicon substrate when the pressure is 1333 Pa (10 Torr) or lower, and the temperature is 300°C or higher and 950°C or lower.

In the nucleation step of SiC, when a temperature condition is higher than 950°C, the reaction between the single crystal silicon substrate and the raw material gas proceeds, and the nucleation of SiC on the surface of the single crystal silicon substrate cannot be formed. On the other hand, when a temperature is lower than 300°C, the temperature is too low, thereby making efficient nucleation of SiC impossible.

Additionally, considering the third step described next at this point, if the temperature is lower than 800°C during the third step, the heteroepitaxial growth of SiC does not proceed. Thereupon, from the time of the second step, for example, the temperature of nucleation of SiC can be set preferably between 800°C or higher and 950°C and lower, more preferably between 850°C or higher and 900°C or lower. By making the temperature of the second step 800°C or higher and 950°C or lower, the temperature range for the nucleation step of SiC (Second Step) and the following third step, which is the formation of the 3C-SiC single crystal film, can be overlapped, in particular, these second and third steps can be performed under the same temperature condition.

Moreover, keeping the pressure at 1333 Pa (10 Torr) or lower is efficient because it prevents secondary or higher-order reactions, such as the reaction of the reactive active species with the raw material gas in the gas phase. The lower pressure limit is not particularly limited but can be 13 Pa (0.1 Torr), for example. Moreover, the pressure, as in the temperature, can be the same conditions in the second and third steps.

In the example shown in FIG. 2, this second step and the following third step are performed on the same conditions, the same pressure, and the same retention temperature (900°C).

### <Third Step>

In addition, the formation step of the 3C-SiC single crystal film, which is the third step, is performed on condition of the pressure of 1333 Pa (10 Torr) or lower and the temperature of 800°C or higher and lower than 1200°C. With such conditions, the SiC single crystal can be efficiently grown, thereby forming the 3C-SiC single crystal film.

Moreover, in the present invention, the pressure in the third step is made to be 1333 Pa (10 Torr) or lower, thus polycrystallization of the formed 3C-SiC can be prevented, and the secondary or higher-order reactions can be suppressed in the vapor phase as described above, and the 3C-SiC single crystal film can be formed reliably and efficiently. Simultaneously, a vacancy is formed directly under the 3C-SiC single crystal film, thereby obtaining an effect of stress-relaxing of an entire heteroepitaxial layer. In addition, the pressure can preferably be 133 Pa (1 Torr) or lower to form the above vacancy more reliably and to obtain the above stress-relaxing effect more reliably. The lower pressure limit is not limited but can be 13 Pa (0.1 Torr), for example.

Furthermore, concerning the temperature, the SiC single crystal growth does not progress at lower than 800°C as described above, and the slip dislocation may be generated at 1200°C or higher. Consequently, the temperature is defined between 800°C or higher and lower than 1200°C as described above.

In the example shown in FIG. 2, the second and third steps are on the same conditions, as described above, the nucleation of SiC and the formation of the 3C-SiC single crystal film are performed in succession.

Since the film thickness at this time depends on the pressure and temperature, the formation time can be determined appropriately based on the pressure and temperature conditions determined to achieve the desired film thickness.

In this case, the film thickness of the 3C-SiC single crystal film can be formed within a thin film of about 2 nm to a thick film of several µm, for example.

In addition, a layered growth in two-dimensional growth mode shown in FIG. 2 is a layer by layer epitaxial growth.

When GaN is grown on the 3C-SiC single crystal film grown in such a way, a heteroepitaxial wafer having a GaN layer with excellent quality can be obtained.

In this event, GaN growth is performed for film-formation by MOCVD using organometallic materials such as trimethylgallium and trimethylammonium to grow GaN of about 3 µm.

Furthermore, by growing Si on the 3C-SiC single crystal film grown in this way, it is possible to obtain a substrate with a high-quality Si epitaxial layer. With this structure, in the case of power devices such as IGBTs, for example, the 3C-SiC single crystal film serves as a breakdown-voltage-retaining layer in the IGBT. The dielectric breakdown electric field strength of silicon is 0.3 MV/cm, while the dielectric breakdown electric field strength of 3C-SiC is 3 MV/cm; thus, that of 3C-SiC is ten times larger. That is, the same performance can be obtained with one-tenth of the thickness of a breakdown-voltage-retaining layer of a conventional silicon IGBT. Needless to say, it is not necessary to form the breakdown-voltage-retaining layer only with the 3C-SiC single crystal film, and a combination of SiC and Si is also sufficient. SiC is grown to a predetermined thickness in this way, and then the Si epitaxial layer is grown thereon. In conventional SiC devices, a gate insulator film is formed using SiC, which has problems with reliability. However, silicon is grown in this structure, and then a gate insulator film is grown using this silicon, thus the same gate reliability as the conventional silicon IGBT can be ensured. Moreover, a thickness of the silicon layer in this case can be determined discretionary as long as the layer is thicker than the required gate structure.

### <Fourth Step>

Then, as a fourth step, a heteroepitaxial film is produced by separating and then delaminating a formed 3C-SiC single crystal film from a single crystal silicon substrate along a vacancy.

FIG. 3 shows an example of a state when a heteroepitaxial film is produced by delaminating the 3C-SiC single crystal film from the single crystal silicon substrate. As shown on the upper side of FIG. 3, a heteroepitaxial film 3 has been formed on a single crystal silicon substrate 1 by previous steps so far. In addition, the heteroepitaxial film 3 includes at least the 3C-SiC single crystal film; for example, the case with only the 3C-SiC single crystal film, the case including a 3C-SiC film and a GaN film in order from the single crystal silicon substrate side, and the case including the 3C-SiC film and a Si film in order from the single crystal silicon substrate side or the like can be mentioned. At the same time, a vacancy region 2 (a region where a vacancy of an interface between 3C-SiC and silicon is formed and also referred to as a vacancy formed portion) is formed between the single crystal silicon substrate 1 and the heteroepitaxial film 3 (more specifically, between the single crystal silicon substrate 1 and the 3C-SiC film in the heteroepitaxial film 3).

In addition, as shown in the middle of FIG. 3, a protective film 4 is formed on the 3C-SiC single crystal film (in other words, on the surface of the heteroepitaxial film 3). As a material of this protective film 4, for example, resin such as polyimide or an oxide film deposited by CVD can be mentioned.

Then, as shown on the lower side of FIG. 3, as the fourth step, the heteroepitaxial film 3, having the 3C-SiC single crystal film, can be separated and delaminated and then obtained from the single crystal silicon substrate 1, making the vacancy region 2 a border therebetween.

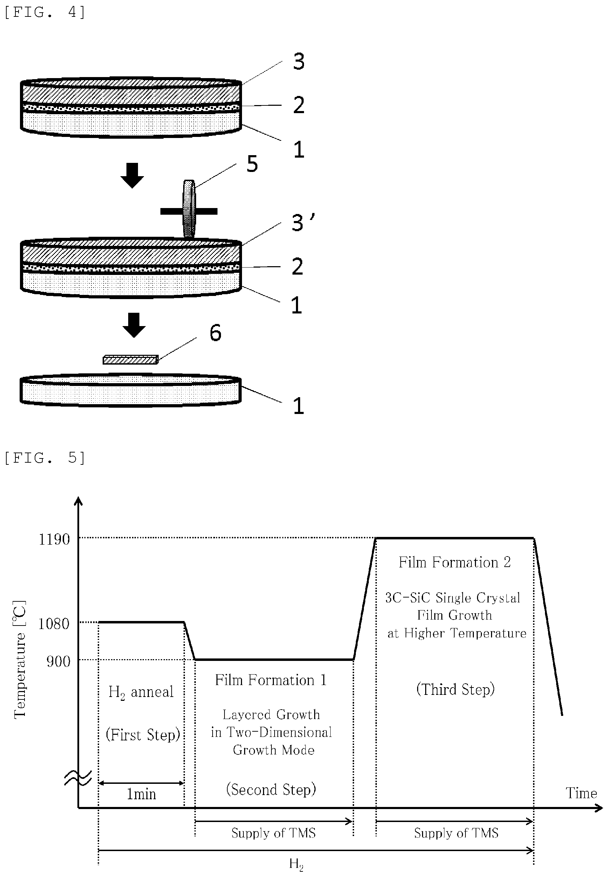

Moreover, FIG. 4 shows another example of a state of producing a heteroepitaxial film. In the example of FIG. 4, a device is formed on a 3C-SiC single crystal film (on the surface of a heteroepitaxial film 3) (<Device Step> in FIG. 1: a heteroepitaxial film 3' after the formation of the device), then for example, dicing is performed by a dicing apparatus 5 (<Dicing Step> in FIG. 1), and then the heteroepitaxial film 3' is separated and delaminated along a vacancy region 2 as the fourth step. In this case, the heteroepitaxial film 3' obtained by the delamination becomes a chip shape (chip 6). For example, a clipper or a picker can be used for the above delamination, and removal from a single crystal silicon substrate 1 can be easily performed by these means. After that, the device can be produced by attaching to another wafer or a substrate made of a different material.

In addition, scribe can be performed instead of dicing.

As still another example, after forming the device on the 3C-SiC single crystal film, a protective film is formed, and then the fourth step can be performed. Moreover, the protective film is formed after forming the device on the 3C-SiC single crystal film and cutting out of the device along a scribe line of the device, and then the fourth step may be performed. Furthermore, the fourth step can be performed after adhesion with an adhesive to a holding stage (for example, various substrates) with or without the protective film.

Thus, depending on a desired form of the heteroepitaxial film, the necessary treatment can be performed between the third step and the fourth step as appropriate.

With the inventive method for producing the heteroepitaxial film, the heteroepitaxial film can be efficiently formed with the vacancy, and even when the device has been already formed, damage to that device is minimized due to separation and delamination along the vacancy region, thus the heteroepitaxial film can be obtained efficiently and easily. Moreover, the separation can be performed at the interface between the 3C-SiC single crystal film and the single crystal silicon substrate, thus a loss of the single crystal silicon substrate obtained after delamination can be made extremely small and then the substrate can be reused for the following production of the heteroepitaxial film.

### (Second Embodiment)

FIG. 5 shows an example of a growth sequence from the first step to the third step in the second embodiment.

### <First Step>

To begin with, a single crystal silicon substrate is placed in an RP-CVD apparatus, and a native oxide film on the surface is removed by H₂ anneal. This can be done as in the first embodiment.

### <Second Step>

Then, as a nucleation step of SiC, the single crystal silicon substrate is set at a temperature of 300°C or higher and 950°C or lower, preferably 800°C or higher and 950°C or lower, more preferably 850°C or higher and 900°C or lower, and then monomethylsilane or trimethylsilane is introduced as a raw material gas for SiC. The time for nucleation can be five minutes, for example.

### <Third Step >

Then, as a formation step of the 3C-SiC single crystal film, the temperature of the single crystal silicon substrate is raised to 1000°C or higher and lower than 1200°C, and then monomethylsilane or trimethylsilane is introduced as a raw material gas of SiC.

The third step, which is the formation step of this 3C-SiC single crystal film, raises one or more of the pressure and the temperature higher than the second step, which is the nucleation step of SiC, thereby facilitating growth at a high rate (change between steps). Moreover, raising one or more of the pressure and the temperature during the third step can facilitate growth at a high rate (change within a step). Only one of the above change between steps or change within the step can be made, or both can be made.

Then, the temperature in the third step can be made to 1000°C or higher and lower than 1200°C. In this case, heteroepitaxial growth can be controlled by transport of a supplied gas. A plane orientation of the single crystal silicon substrate is not subjected to restrictions and can easily be made to accommodate a substrate having a large diameter, such as 300 mm.

FIG. 5 shows an example of only performing the change between steps. The second step is performed by maintaining 900°C, and the third step is performed by maintaining 1190°C (the pressure is the same for the second and third steps, for example). However, not being limited thereto, for example, the second step can be carried out while maintaining at 900°C, then the introduction of trimethylsilane is stopped once, and then, as the third step, the introduction of trimethylsilane can be restarted in which a temperature is maintained on condition at 900°C, or higher than 900°C and lower than 1190°C for a predetermined time, and then the temperature can be raised to 1190°C and maintained.

In addition, the growth in FIG. 5 is performed at a higher temperature (1190°C) than the first embodiment (900°C), the reason why the heteroepitaxial growth is possible even on such conditions may be due to H₂ flow during the temperature rise and the effects of the H₂, or the effects of changing the temperature during growth (i.e., when transitioned from the second step to the third step) which changes growth mode. As shown in FIG. 5, the sequence in FIG. 5 also results in two-dimensional growth from nucleation.

In particular, the pressure is set to 1333 Pa (10 Torr) or lower, preferably 133 Pa (1 Torr) or lower, in the nucleation step of SiC and the initial stage of the formation step of 3C-SiC single crystal film to form a vacancy directly under the 3C-SiC single crystal film. Then, the pressure is changed to a higher condition than the initial stage within a range of 1333 Pa (10 Torr) or lower, thereby achieving both stress-relaxing of the entire heteroepitaxial layer and efficient formation of the 3C-SiC single crystal film.

Then, by growing GaN or Si on the 3C-SiC single crystal film grown in this way, the substrate having a high-quality GaN epitaxial layer or Si epitaxial layer can be obtained.

### <Fourth Step>

The formed 3C-SiC single crystal film is separated and delaminated from the single crystal silicon substrate along the vacancy, thereby producing the heteroepitaxial film. This can be performed in the same manner as in the first embodiment.

### (Third Embodiment)

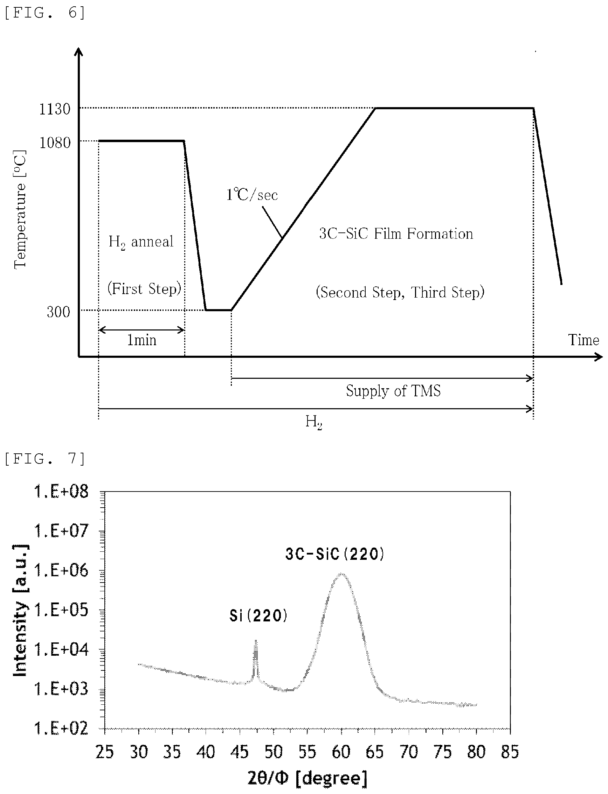

FIG. 6 shows an example of a growth sequence of the third embodiment.

### <First Step>

To begin with, a single crystal silicon substrate is placed in an RP-CVD apparatus, and a native oxide film on a surface of the substrate is removed by H₂ anneal as on a similar condition in the first embodiment.

### <Second Step, Third Step>

Then, in order to perform the nucleation of SiC and subsequent formation of a 3C-SiC single crystal film in succession on the surface of the single crystal silicon substrate, a temperature is gradually raised from a range of 300°C or higher and 950°C or lower to a range of 1000°C or higher and lower than 1200°C, while introducing monomethylsilane or trimethylsilane as a raw material gas. In this way, the second step and third step can be performed in succession while raising the temperature.

A rate of temperature rise is preferably 0.5°C/sec or higher and 2°C/sec or lower, for example. The rate of temperature rise at this level is not too fast rate of temperature rise, thus, the deviation between the set temperature and the actual temperature can be effectively prevented, and the temperature control can be properly performed. Moreover, the rate of temperature rise is not too slow; thus, it can prevent facilitating a generation of ununiform nucleation due to a long transit time of a temperature zone for SiC nucleation or facilitating a generation of a defect during heteroepitaxial growth.

In this case, the temperature may be raised to a predetermined temperature within a range of 1000°C or higher and lower than 1200°C, then the growth may be stopped there, or the growth can be continued until a predetermined film thickness is achieved while maintaining at that temperature. Moreover, the growth may be stopped when the predetermined film thickness is achieved along with the temperature rise, even if the temperature has reached 1000°C or higher but has not reached the predetermined temperature described above. A gradual acceleration of the forming rate of the film is enabled by growth with a continuously changing growth mode (changing from nucleation to two-dimensional growth) by growing with varying temperatures.

In FIG. 6, the temperature rises from 300°C to 1130°C at the rate of temperature rise of 1°C/sec, then is maintained at 1130°C intact for the predetermined time.

In particular, the pressure is set to 1333 Pa (10 Torr) or lower, preferably 133 Pa (1 Torr) or lower, in the nucleation step of SiC and the initial stage of the formation step of 3C-SiC single crystal film to form a vacancy directly under the 3C-SiC single crystal film. Then, the pressure is changed to a higher condition than the initial stage within a range of 1333 Pa (10 Torr) or lower, thereby achieving both stress-relaxing of the entire heteroepitaxial layer and efficient formation of the 3C-SiC single crystal film.

Then, by growing GaN or Si on the 3C-SiC single crystal film grown in this way, the substrate having an excellent quality GaN epitaxial layer or Si epitaxial layer can be obtained.

### <Fourth Step>

The formed 3C-SiC single crystal film is separated and delaminated from the single crystal silicon substrate along the vacancy, thereby producing the heteroepitaxial film. This can be performed in the same manner as in the first embodiment.

### EXAMPLE

Hereinafter, the present invention will be specifically described with reference to Examples and Comparative Examples of the present invention. However, the present invention is not limited thereto.

### (Example 1)

High-resistivity single crystal silicon substrates having a diameter of 300 mm, plane orientation (111), and boron-doped were provided, and wafers were placed on a susceptor in a reactor of an RP-CVD apparatus, and then H₂ anneal was performed at 1080°C for one minute (First Step).

Then, a trimethylsilane gas was introduced at a growth temperature of 900°C and a growth pressure of 133 Pa (1 Torr), and a nucleation step of SiC (Second Step) and 3C-SiC single crystal film growth (Third Step) was performed. As a result of five minutes of growth, the film thickness was 13 nm.

Subsequently, when an XRD (X-ray diffraction) spectrum was confirmed in in-plane arrangement, a peak of 3C-SiC (220) parallel to Si (220) was successfully confirmed, as shown in a graph of XRD analysis results in FIG. 7, and the growth of single crystal 3C-SiC film was confirmed.

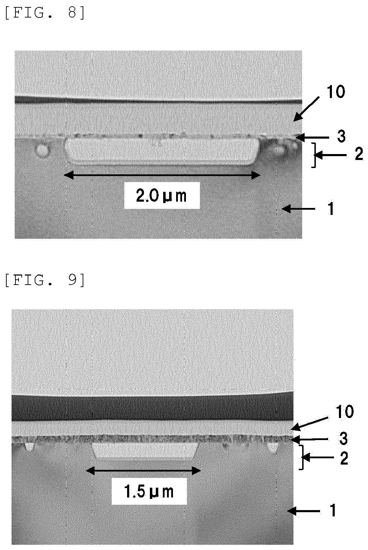

Moreover, FIG. 8 shows a cross-sectional TEM image of the film. As a result, a formation of a vacancy (vacancy formed portion 2) directly under the 3C-SiC single crystal film (heteroepitaxial film 3) was confirmed. In addition, reference sign 10 indicates a surface-protecting film for cross-sectional TEM imaging.

Subsequently, a surface of a protective film on the 3C-SiC single crystal film was coated with an adhesive and bonded to a quartz substrate. Then, with this substrate in a state of being chucked, peeling off was performed, then separation and delamination of the 3C-SiC single crystal film (heteroepitaxial film) was achieved along the vacancy formed portion at an interface between 3C-SiC and silicon (Fourth Step).

As still another delamination method, dicing with the size of 1 mm × 1 mm was performed from the 3C-SiC single crystal film side (the dicing depth was slightly deeper than the thickness of the 3C-SiC single crystal film) to the substrate in which the 3C-SiC single crystal film was grown, then a surface thereof was adsorbed by a clipper and then the 3C-SiC single crystal film was successfully delaminated as a chip at the vacancy formed portion.

### (Example 2)

High-resistivity single crystal silicon substrate having a diameter of 300 mm, plane orientation (111), and boron-doped were provided, and wafers were placed on a susceptor in a reactor of an RP-CVD apparatus, and then H₂ anneal was performed at 1080°C for one minute (First Step).

Subsequently, a trimethylsilane gas was introduced at a growth temperature of 900°C for five minutes as a second step (Nucleation Step of SiC Nucleus).

Then, the growth temperature was raised to 1190°C as a third step (Formation Step of 3C-SiC single crystal film), and a trimethylsilane gas was introduced to grow a 3C-SiC single crystal film. The growth pressure here was uniformly 133 Pa (1 Torr). As a result of growth for one minute, film thickness was about 30 nm.

After the formation, when an XRD spectrum was confirmed in an in-plane arrangement, a peak of 3C-SiC (220) parallel to Si (220) was successfully confirmed as in Example 1, and the growth of a single crystal 3C-SiC film was confirmed.

Moreover, FIG. 9 shows a cross-sectional TEM image of the film. As a result, a formation of a vacancy directly under the 3C-SiC single crystal film was confirmed.

Subsequently, when the fourth step was performed as in Example 1 using an adhesive and a quartz substrate, then delamination of the 3C-SiC single crystal film was achieved along a vacancy formed portion at an interface between 3C-SiC and silicon.

When still another delamination method was performed as in Example 1, the 3C-SiC single crystal film was successfully delaminated as a chip at the vacancy formed portion.

### (Example 3)

A 3C-SiC single crystal film was formed on the same condition as in Example 1, except that a growth pressure was 1333 Pa (10 Torr) and a growth temperature was 950°C in the second step and the third step. As a result, a film thickness was about 20 nm.

Subsequently, when an XRD spectrum was confirmed in an in-plane arrangement, a peak of 3C-SiC (220) parallel to Si (220) was successfully confirmed, and the growth of a single crystal 3C-SiC film was confirmed. Moreover, a formation of a vacancy directly under the 3C-SiC single crystal film was confirmed.

Furthermore, when the fourth step was performed as in Example 1 using an adhesive and a quartz substrate, then delamination of the 3C-SiC single crystal film was achieved along a vacancy formed portion at an interface between 3C-SiC and silicon.

### (Example 4)

A 3C-SiC single crystal film was formed on the same condition as in Example 2, except that a growth temperature was 300°C and 800°C in the second step and the third step, respectively. As a result, a film thickness was about 12 nm.

Subsequently, when an XRD spectrum was confirmed in an in-plane arrangement, a peak of 3C-SiC (220) parallel to Si (220) was successfully confirmed, and the growth of a single crystal 3C-SiC film was confirmed. Moreover, a formation of a vacancy directly under the 3C-SiC single crystal film was confirmed.

Furthermore, when the fourth step was performed as in Example 2 using an adhesive and a quartz substrate, then delamination of the 3C-SiC single crystal film was achieved along a vacancy formed portion at an interface between 3C-SiC and silicon.

### (Comparative Example 1)

A 3C-SiC single crystal film was formed on the same condition as in Example 2, except that a growth pressure was 3999 Pa (30 Torr) in the second step and the third step. As a result, a film thickness was about 33 nm.

Subsequently, when an XRD spectrum was confirmed in an in-plane arrangement, a peak of 3C-SiC (220) parallel to Si (220) was successfully confirmed, and the growth of a single crystal 3C-SiC film was confirmed. However, a formation of a vacancy directly under the 3C-SiC single crystal film could not be confirmed.

Furthermore, delamination of the 3C-SiC single crystal film was attempted as in Example 2 using an adhesive and a quartz substrate, but delamination could not be achieved. This is considered to be due to a failure to form the vacancy described above.

### (Comparative Example 2)

A 3C-SiC single crystal film was formed on the same condition as in Example 2, except that a growth temperature was 200°C or 1000°C in the second step. As a result, a film thickness was about 2 nm and 4 nm, respectively.

The film thickness formed in such a way was extremely thin compared with Example 2, and the efficiency thereof was significantly inferior. This is considered that the temperature in the second step was too high or too low, thus nucleation of SiC was insufficient, and consequently, little heteroepitaxial growth was made in the third step.

### (Comparative Example 3)

A 3C-SiC single crystal film was formed on the same condition as in Example 2, except that a growth temperature was 700°C or 1250°C in the third step. As a result, a film thickness was about 7 nm and 50 nm, respectively.

Thus, in the case of 700°C, the film thickness formed was extremely thin compared with Example 2, and the efficiency thereof was significantly inferior. Moreover, a slip dislocation was generated in the case of 1250°C.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a heteroepitaxial film, including a step of heteroepitaxially growing a 3C-SiC single crystal film on a single crystal silicon substrate and then delaminating the 3C-SiC single crystal film from the single crystal silicon substrate, the method comprising: with using a reduced-pressure CVD apparatus,
a first step of removing a native oxide film on a surface of the single crystal silicon substrate by hydrogen baking;
a second step of performing nucleation of SiC on the single crystal silicon substrate on condition of pressure of 1333 Pa or lower and a temperature of 300°C or higher and 950°C or lower and a third step of forming the 3C-SiC single crystal film by growing a SiC single crystal and forming a vacancy directly under the 3C-SiC single crystal film on condition of pressure of 1333 Pa or lower and a temperature of 800°C or higher and lower than 1200°C, while supplying a source gas containing carbon and silicon into the reduced-pressure CVD apparatus; and
a fourth step of producing the heteroepitaxial film by separating and delaminating the 3C-SiC single crystal film from the single crystal silicon substrate along the vacancy.

2. The method for producing a heteroepitaxial film according to claim 1, wherein
the source gas is monomethylsilane or trimethylsilane.

3. The method for producing a heteroepitaxial film according to claim 1 or 2, wherein
the first step is performed on condition of a temperature of 1000°C or higher and 1200°C or lower.

4. The method for producing a heteroepitaxial film according to any one of claims 1 to 3, wherein
the third step is performed on condition of pressure of 133 Pa or lower.

5. The method for producing a heteroepitaxial film according to any one of claims 1 to 4, wherein
the third step is performed with one or more of pressure and temperature higher than the condition of the second step.

6. The method for producing a heteroepitaxial film according to claim 5, wherein
the third step is performed on condition of a temperature of 1000°C or higher and lower than 1200°C.

7. The method for producing a heteroepitaxial film according to any one of claims 1 to 6, wherein
one or more of the pressure and temperature are raised higher during the third step.

8. The method for producing a heteroepitaxial film according to claim 7, wherein
the second step and the third step are performed on condition of gradually raising a temperature from a range from 300°C or higher to 950°C or lower to the range from 1000°C or higher to lower than 1200°C,
thereby performing the nucleation of SiC and the formation of the 3C-SiC single crystal film following the nucleation of SiC in succession.

9. The method for producing a heteroepitaxial film according to claim 8, wherein
the temperature rise is at a rate of temperature rise of 0.5°C/sec or faster and 2°C/sec or slower.

10. The method for producing a heteroepitaxial film according to any one of claims 1 to 9, wherein
after the third step and before the fourth step, a GaN layer is formed on a surface of the formed 3C-SiC single crystal film by further growing GaN thereon.

11. The method for producing a heteroepitaxial film according to any one of claims 1 to 9, wherein
after the third step and before the fourth step, a Si layer is formed on a surface of the formed 3C-SiC single crystal film by further growing Si thereon.

12. The method for producing a heteroepitaxial film according to any one of claims 1 to 11, wherein
after the third step, a protective film is formed on the formed 3C-SiC single crystal film, and then the fourth step is performed.

13. The method for producing a heteroepitaxial film according to any one of claims 1 to 11, wherein
after the third step, a device is formed and a protective film is formed on the formed 3C-SiC single crystal film, and then the fourth step is performed.

14. The method for producing a heteroepitaxial film according to any one of claims 1 to 11, wherein
after the third step, the device is formed on the formed 3C-SiC single crystal film, and the protective film is formed after the device is cut out along a scribe line of the device, and then the fourth step is performed.

## Patentansprüche

1. Verfahren zur Herstellung eines heteroepitaktischen Films, umfassend einen Schritt des heteroepitaktischen Aufwachsens einer 3C-SiC-Einkristallschicht auf einem Einkristall-Siliziumsubstrat und des anschließenden Ablösens der 3C-SiC-Einkristallschicht vom Einkristall-Siliziumsubstrat, wobei das Verfahren umfasst: unter Verwendung einer CVD-Anlage mit reduziertem Druck,
einen ersten Schritt zum Entfernen einer nativen Oxidschicht auf einer Oberfläche des Einkristall-Siliziumsubstrats durch Wasserstoffausglühen;
einen zweiten Schritt zum Durchführen von SiC-Keimbildung auf dem Einkristall-Siliziumsubstrat unter Bedingungen eines Drucks von 1333 Pa oder weniger und einer Temperatur von 300 °C oder mehr und 950 °C oder weniger sowie einen dritten Schritt zum Bilden der 3C-SiC-Einkristallschicht durch Aufwachsen eines SiC-Einkristalls und Bilden einer Leerstelle direkt unter der 3C-SiC-Einkristallschicht unter Bedingungen eines Drucks von 1333 Pa oder weniger und einer Temperatur von 800 °C oder mehr und weniger als 1200 °C, während in die CVD-Anlage mit reduziertem Druck ein Kohlenstoff und Silizium enthaltendes Ausgangsgas eingeleitet wird; und
einen vierten Schritt zur Herstellung des heteroepitaktischen Films durch Abtrennen und Ablösen der 3C-SiC-Einkristallschicht vom Einkristall-Siliziumsubstrat entlang der Leerstelle.

2. Verfahren zur Herstellung eines heteroepitaktischen Films nach Anspruch 1, wobei
das Ausgangsgas Monomethylsilan oder Trimethylsilan ist.

3. Verfahren zur Herstellung eines heteroepitaktischen Films nach Anspruch 1 oder 2, wobei
der erste Schritt unter der Bedingung einer Temperatur von 1000 °C oder höher und 1200 °C oder niedriger durchgeführt wird.

4. Verfahren zur Herstellung eines heteroepitaktischen Films nach einem der Ansprüche 1 bis 3, wobei
der dritte Schritt unter der Bedingung eines Drucks von 133 Pa oder weniger durchgeführt wird.

5. Verfahren zur Herstellung eines heteroepitaktischen Films nach einem der Ansprüche 1 bis 4, wobei
der dritte Schritt durchgeführt wird bei einem Druck und/oder einer Temperatur, die höher sind/ist als die Bedingung(en) des zweiten Schritts.

6. Verfahren zur Herstellung eines heteroepitaktischen Films nach Anspruch 5, wobei
der dritte Schritt unter der Bedingung einer Temperatur von 1000 °C oder höher und niedriger als 1200 °C durchgeführt wird.

7. Verfahren zur Herstellung eines heteroepitaktischen Films nach einem der Ansprüche 1 bis 6, wobei
der Druck und/oder die Temperatur während des dritten Schritts erhöht werden/wird.

8. Verfahren zur Herstellung eines heteroepitaktischen Films nach Anspruch 7, wobei
der zweite Schritt und der dritte Schritt unter der Bedingung durchgeführt werden, dass die Temperatur schrittweise von einem Bereich von 300 °C oder höher bis 950 °C oder niedriger auf den Bereich von 1000 °C oder höher bis unter 1200 °C erhöht wird,
wodurch nacheinander die Keimbildung von SiC und die Bildung der 3C-SiC-Einkristallschicht im Anschluss an die Keimbildung von SiC durchgeführt werden.

9. Verfahren zur Herstellung eines heteroepitaktischen Films nach Anspruch 8, wobei
der Temperaturanstieg mit einer Geschwindigkeit des Temperaturanstiegs von 0,5 °C/s oder schneller und 2 °C/s oder langsamer erfolgt.

10. Verfahren zur Herstellung eines heteroepitaktischen Films nach einem der Ansprüche 1 bis 9, wobei
nach dem dritten Schritt und vor dem vierten Schritt eine GaN-Schicht auf einer Oberfläche der gebildeten 3C-SiC-Einkristallschicht gebildet wird, indem weiter GaN darauf aufgewachsen wird.

11. Verfahren zur Herstellung eines heteroepitaktischen Films nach einem der Ansprüche 1 bis 9, wobei
nach dem dritten Schritt und vor dem vierten Schritt eine Si-Schicht auf einer Oberfläche der gebildeten 3C-SiC-Einkristallschicht gebildet wird, indem weiter Si darauf aufgewachsen wird.

12. Verfahren zur Herstellung eines heteroepitaktischen Films nach einem der Ansprüche 1 bis 11, wobei
nach dem dritten Schritt ein Schutzfilm auf der gebildeten 3C-SiC-Einkristallschicht gebildet wird und anschließend der vierte Schritt durchgeführt wird.

13. Verfahren zur Herstellung eines heteroepitaktischen Films nach einem der Ansprüche 1 bis 11, wobei
nach dem dritten Schritt eine Vorrichtung gebildet wird und ein Schutzfilm auf der gebildeten 3C-SiC-Einkristallschicht gebildet wird und anschließend der vierte Schritt durchgeführt wird.

14. Verfahren zur Herstellung eines heteroepitaktischen Films nach einem der Ansprüche 1 bis 11, wobei
nach dem dritten Schritt die Vorrichtung auf der gebildeten 3C-SiC-Einkristallschicht gebildet wird und der Schutzfilm gebildet wird, nachdem die Vorrichtung entlang einer Ritzlinie der Vorrichtung ausgeschnitten wurde, und anschließend der vierte Schritt durchgeführt wird.

## Revendications

1. Procédé de production d'un film hétéroépitaxial, comprenant une étape de croissance hétéroépitaxiale d'un film monocristallin de 3C-SiC sur un substrat de silicium monocristallin, puis de décollement du film monocristallin de 3C-SiC du substrat de silicium monocristallin, le procédé comprenant : à l'aide d'un appareil de CVD à pression réduite,
une première étape d'élimination d'un film d'oxyde natif sur une surface du substrat de silicium monocristallin par cuisson à l'hydrogène ;
une deuxième étape de réalisation de la nucléation de SiC sur le substrat de silicium monocristallin dans des conditions de pression de 1 333 Pa ou moins et de température de 300 °C ou plus et de 950 °C ou moins et une troisième étape de formation du film monocristallin de 3C-SiC par croissance d'un monocristal de Sic et de formation d'une lacune directement sous le film monocristallin de 3C-SiC dans des conditions de pression de 1 333 Pa ou moins et de température de 800 °C ou plus et inférieure à 1 200 °C, tout en alimentant un gaz source contenant du carbone et du silicium dans l'appareil de CVD à pression réduite ; et
une quatrième étape de production du film hétéroépitaxial par séparation et décollement du film monocristallin de 3C-SiC du substrat de silicium monocristallin le long de la lacune.

2. Procédé de production d'un film hétéroépitaxial selon la revendication 1, dans lequel
le gaz source est le monométhylsilane ou le triméthylsilane.

3. Procédé de production d'un film hétéroépitaxial selon la revendication 1 ou 2, dans lequel
la première étape est réalisée dans des conditions de température de 1 000 °C ou plus et de 1 200 °C ou moins.

4. Procédé de production d'un film hétéroépitaxial selon l'une quelconque des revendications 1 à 3, dans lequel
la troisième étape est réalisée dans des conditions de pression de 133 Pa ou moins.

5. Procédé de production d'un film hétéroépitaxial selon l'une quelconque des revendications 1 à 4, dans lequel
la troisième étape est réalisée avec une ou plusieurs parmi la pression et la température supérieures aux conditions de la deuxième étape.

6. Procédé de production d'un film hétéroépitaxial selon la revendication 5, dans lequel
la troisième étape est réalisée dans des conditions de température de 1 000 °C ou plus et inférieure à 1 200 °C.

7. Procédé de production d'un film hétéroépitaxial selon l'une quelconque des revendications 1 à 6, dans lequel
une ou plusieurs parmi la pression et la température sont élevées davantage lors de la troisième étape.

8. Procédé de production d'un film hétéroépitaxial selon la revendication 7, dans lequel
la deuxième étape et la troisième étape sont réalisées dans des conditions d'élévation progressive de la température d'une plage de 300 °C ou plus à 950 °C ou moins jusqu'à une plage de 1 000 °C ou plus à moins de 1 200 °C,
réalisant ainsi la nucléation du SiC et la formation du film monocristallin de 3C-SiC suite à la nucléation de Sic consécutivement.

9. Procédé de production d'un film hétéroépitaxial selon la revendication 8, dans lequel
l'élévation de température est à une vitesse d'élévation de température de 0,5 °C/s ou plus vite et de 2 °C/s ou plus lentement.

10. Procédé de production d'un film hétéroépitaxial selon l'une quelconque des revendications 1 à 9, dans lequel
après la troisième étape et avant la quatrième étape, une couche de GaN est formée sur une surface du film monocristallin de 3C-SiC formé, par croissance en outre de GaN sur celle-ci.

11. Procédé de production d'un film hétéroépitaxial selon l'une quelconque des revendications 1 à 9, dans lequel
après la troisième étape et avant la quatrième étape, une couche de Si est formée sur une surface du film monocristallin de 3C-SiC formé, par croissance en outre de Si sur celle-ci.

12. Procédé de production d'un film hétéroépitaxial selon l'une quelconque des revendications 1 à 11, dans lequel
après la troisième étape, un film protecteur est formé sur le film monocristallin de 3C-SiC formé, puis la quatrième étape est réalisée.

13. Procédé de production d'un film hétéroépitaxial selon l'une quelconque des revendications 1 à 11, dans lequel
après la troisième étape, un dispositif est formé et un film protecteur est formé sur le film monocristallin de 3C-SiC formé, puis la quatrième étape est réalisée.

14. Procédé de production d'un film hétéroépitaxial selon l'une quelconque des revendications 1 à 11, dans lequel
après la troisième étape, le dispositif est formé sur le film monocristallin de 3C-SiC formé, et le film protecteur est formé après découpe du dispositif le long d'une ligne de traçage du dispositif, puis la quatrième étape est réalisée.
